Europäisches Patentamt

European Patent Office

Office européen des brevets

(11) Veröffentlichungsnummer: **0 382 865**
**A1**

## (12) EUROPÄISCHE PATENTANMELDUNG

(21) Anmeldenummer: 89102515.7

(22) Anmeldetag: 14.02.89

(51) Int. Cl.⁵: H01L 27/092

(43) Veröffentlichungstag der Anmeldung:
22.08.90 Patentblatt 90/34

(84) Benannte Vertragsstaaten:
AT BE CH DE ES FR GB GR IT LI LU NL SE

(71) Anmelder: **Siemens Aktiengesellschaft**
**Wittelsbacherplatz 2**
**D-8000 München 2(DE)**

(72) Erfinder: **Harter, Johann, Dr. rer.nat.**
**Münchener Strasse 9**
**D-8069 Reichertshausen(DE)**

(54) **Anordnung zur Verminderung von Latch-up-Störanfälligkeit bei CMOS-Halbleiterschaltungen.**

(57) Anordnung zur Verminderung des Latch-up-Effekts bei CMOS-Schaltungen durch Verwendung eines Guard Ring Gn, der ein im Substrat S angeordnetes Wannengebiet W an der Substratoberfläche umgibt. Der Guard Ring wird grabenförmig bis in eine Tiefe von wenigstens 1 $\mu$m, mindestens jedoch bis in eine Tiefe, die der Hälfte der Tiefe der Wanne

W entspricht, vertieft.

Die Oberfläche des Grabens ist dotiert. Der Graben kann entweder mit einem isolierenden Material oder einem elektrisch leitenden Material gefüllt sein. Zwischen Grabenoberfläche und Grabenfüllung kann eine Isolierschicht, z.B. ein Oxid, angeordnet sein.

# FIG 5

EP 0 382 865 A1

Xerox Copy Centre

Die vorliegende Erfindung betrifft eine Anordnung zur Verminderung von Latch-up-Störanfälligkeit bei CMOS-Halbleiterschaltungen nach dem Oberbegriff des Patentanspruches 1.

Bei Halbleiterschaltungen in CMOS-Technik tritt bekanntlich unter bestimmten elektrischen Bedingungen der sog. "Latch-up-Effekt" auf. Solche Schaltungen weisen deshalb meist sog. "Guard Rings" auf zur Verminderung der Latch-up-Störanfälligkeit. Diese verhindern die genannte Gefahr zwar im statischen Betrieb, jedoch ist beispielsweise bei Anlegen von Versorgungsspannungen oder bei Auftreten bestimmter Schaltvorgänge innerhalb der Halbleiterschaltung die Gefahr des Auftretens von Latch-up trotzdem noch gegeben.

Aufgabe der vorliegenden Erfindung ist es, eine Anordnung zu schaffen, die die Gefahr des Auftretens von Latch-up weiter vermindert.

Dies wird bei einer gattungsgemäßen Anordnung mit den kennzeichnenden Merkmalen des Patentanspruches 1 erreicht. Vorteilhafte Aus- und Weiterbildungen sind in Unteransprüchen gekennzeichnet.

Im folgenden wird die Erfindung anhand der Zeichnung näher erläutert. Es zeigen:

FIG 1 den Schaltplan einer CMOS-Schaltanordnung,

FIG 2 eine Anordnung nach dem Stande der Technik, bei der die für das Entstehen von Latch-up maßgeblichen parasitären Schaltelemente dargestellt sind,

die FIG 3 bis 5 vorteilhafte Ausgestaltungen der Erfindung,

FIG 6 die Erfindung schematisch dargestellt in Draufsicht.

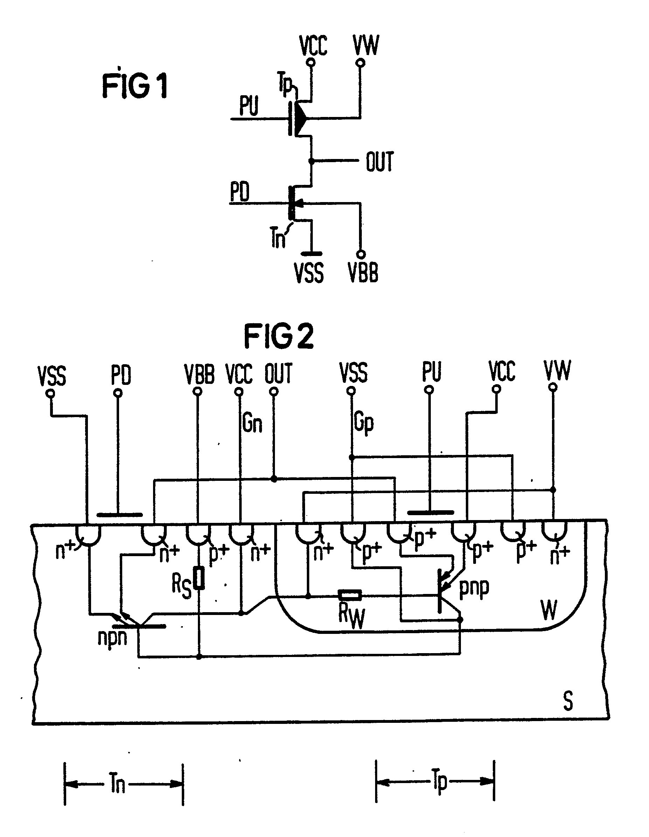

FIG 1 zeigt eine CMOS-Schaltanordnung einer CMOS-Halbleiterschaltung mit einem p-Kanal-Transistor Tp und einem n-Kanal-Transistor Tn nach dem Stande der Technik. Die verwendeten Bezugszeichen werden bei den nachstehenden Figurenbeschreibungen erläutert.

FIG 2 zeigt im Querschnitt einen ersten Substratbereich S von einem ersten Leitfähigkeitstyp, im Beispiel vom p-Typ. Im ersten Substratbereich S ist ein zweiter Substratbereich W angeordnet. Dieser weist einen zweiten Leitfähigkeitstyp auf, der zum ersten Leitfähigkeitstyp entgegengesetzt ist. Im Beispiel ist er demzufolge vom n-Typ. Der zweite Substratbereich W ist, wie bei CMOS allgemein üblich, wannenförmig in den ersten Substratbereich S eingebettet. Er wird deshalb in der Fachwelt meistens mit dem Ausdruck "Wanne" bezeichnet. FIG 2 zeigt weiterhin die beiden MOS-Transistoren Tp und Tn. Der Transistor Tn weist als Source- bzw. Draingebiet je ein n-dotiertes Gebiet n+ auf. Das zugehörige Gate ist mit einem Signal PD beschaltet.

Der elektrische Anschluß des ersten Substratbereiches S erfolgt über ein mit p+ bezeichnetes p-dotiertes Gebiet. Der Anschluß erfolgt entweder an ein als erstes Versorgungspotential VSS der gesamten Halbleiterschaltung dienendes, meist als "Masse" bezeichnetes Potential oder an ein sog. Substratvorspannungspotential VBB, wie hier gezeigt. Substratvorspannungspotentiale VBB werden meist bei integrierten MOS-Halbleiterspeichern (wie z.B. DRAM's) und bei Mikrocomputerbausteinen verwendet.

Der zweite Substratbereich W ist entlang einer Hauptfläche des ersten Substratbereiches S von einem weiteren dotierten Gebiet n+ vom zweiten Leitfähigkeitstyp umgeben. Dies wird üblicherweise als "Guard Ring" Gn bezeichnet. Der Guard Ring Gn ist mit einem zweiten Versorgungspotential VCC der Halbleiterschaltung verbunden. Es weist in der Praxis typische Werte von 3 - 5 V auf.

Eine entsprechend komplementäre Anordnung ist im zweiten Substratbereich W vorgesehen: Er enthält den MOS-Transistor Tp. Seine Source- und Draingebiete sind demzufolge p-dotiert (mit "p+" angedeutet). Der zweite Substratbereich W ist elektrisch mit einem sog. Wannenpotential VW verbunden. Es ist meist gleich dem zweiten Versorgungspotential VCC der Halbleiterschaltung. Das Gate des Transistors Tp ist mit einem Signal PU beschaltet. Weiterhin ist auch im zweiten Substratbereich W ein Guard Ring vorgesehen, der als Wannen-Guard Ring Gp bezeichnet wird. Er ist als p-dotiertes Gebiet (mit "p+" bezeichnet) ausgeführt und mit dem ersten Versorgungspotential VSS verbunden. Anstelle eines in den Figuren gezeigten Anschlusses der Sourcegebiete der Transistoren Tn,Tp an die Potentiale VSS,VDD ist, wie allgemein bekannt, auch ein Anschluß an elektrische Signale möglich.

Die Struktur nach FIG 2 ist bei statischem Betrieb sicher gegen Latch-up, weil das Wannenpotential VW gemäß allgemeinem Fachwissen stets mindestens gleich groß ist wie das betragsmäßig größte an irgendeinem der p-dotierten Gebiete p+ des zweiten Substratbereiches W liegende Potential oder elektrische Signal. Parasitäre Dioden, die sich zwischen den p-dotierten Gebieten p+ des zweiten Substratbereiches W und dem zweiten Substratbereich W selbst ausbilden, sind somit stets gesperrt. Wird jedoch im Betrieb das Signal PU am Gate des Transistors Tp vom zweiten Versorgungspotential VCC auf das erste Versorgungspotential VSS geschaltet, oder wird das zweite Versorgungspotential VCC an die gesamte Halbleiterschaltung als solche angelegt (Power-on-Situation) und liegt dabei am gemeinsamen Ausgang OUT der beiden Transistoren Tn,Tp bereits ein elektrisches Potential (beispielsweise als Teil eines Signals einer anderen integrierten Halbleiterschaltung), so kann eine kapazitive Spannungsteilung zwischen den p-dotierten Gebieten p + des zweiten Substratbereiches W und diesem selbst auftreten, wodurch obengenannte parasitäre Dioden in Flußrichtung gepolt werden können. Dies führt dann zur Injektion von Löchern als Löcherstrom in den zweiten Substratbereich W. Ein Teil des Löcherstroms wird über den Wannen-Guard Ring Gp abgesaugt. Der restliche Teil des Löcherstroms fließt in den ersten Substratbereich S. Je nach Materialbeschaffenheit der ersten und zweiten Substratbereiche S,W und der geometrischen Verhältnisse tritt im ersten Substratbereich S ein relativ großer ohm'scher Spannungsabfall auf. Aufgrund dessen werden weitere parasitäre Dioden, die sich zwischen den n-dotierten Gebieten n + des ersten Substratbereiches S und dem ersten Substratbereich S selbst ausbilden, in Flußrichtung betrieben, was eine Injektion von Elektronen auslöst. Diese Elektronen gelangen in den ersten Substratbereich S und in den zweiten Substratbereich W, wobei im zweiten Substratbereich W ebenfalls ein ohm'scher Spannungsabfall auftritt entsprechend dem bereits beschriebenen Spannungsabfall im ersten Substratbereich S. Dies führt zu einem Absinken des Potentials des zweiten Substratbereiches W unter das Wannenpotential VW. Das Absinken tritt umso stärker auf, je hochohmiger die Spannungsquelle für das Wannenpotential VW ausgeführt ist.

Das Absinken wiederum bewirkt eine noch stärkere Polung der beschriebenen parasitären Dioden, die zwischen den p-dotierten Gebieten p + des zweiten Substratbereiches W und dem zweiten Substratbereich W selbst ausgebildet sind, im Sinne einer positiven Rückkopplung, d.h. einer Mitkopplung. Der gesamte Vorgang stellt sich als der bekannte Latch-up-Effekt dar. Er läßt sich als elektrisches Ersatzschaltbild durch die in FIG 2 eingezeichneten Elemente darstellen: In jedem Substratbereich S,W bildet sich ein parasitärer Bipolar-Transistor aus: Im ersten Substratbereich S ein Transistor npn vom npn-Typ, im zweiten Substratbereich W ein Transistor pnp vom pnp-Typ. Ihre Kollektoren sind wechselweise mit ihren Basen verbunden. Zwischen den Basen der Transistoren npn,pnp und den dotierten Gebieten (p + bzw. n + ) der jeweiligen Anschlüsse für die Potentiale (VBB,VW) der jeweiligen Substratbereiche S,W treten die zuvor beschriebenen ohm'schen Spannungsabfälle entlang ohm'scher Widerstände $R_S$, $R_W$ auf. Die Widerstände $R_S$,$R_W$ sind die üblichen Bahnwiderstände der Substratbereiche S,W. Das n-dotierte Gebiet n + des Guard Rings Gn des ersten Substratbereiches S wirkt dabei in geringem Umfang als Kollektor für Elektronen.

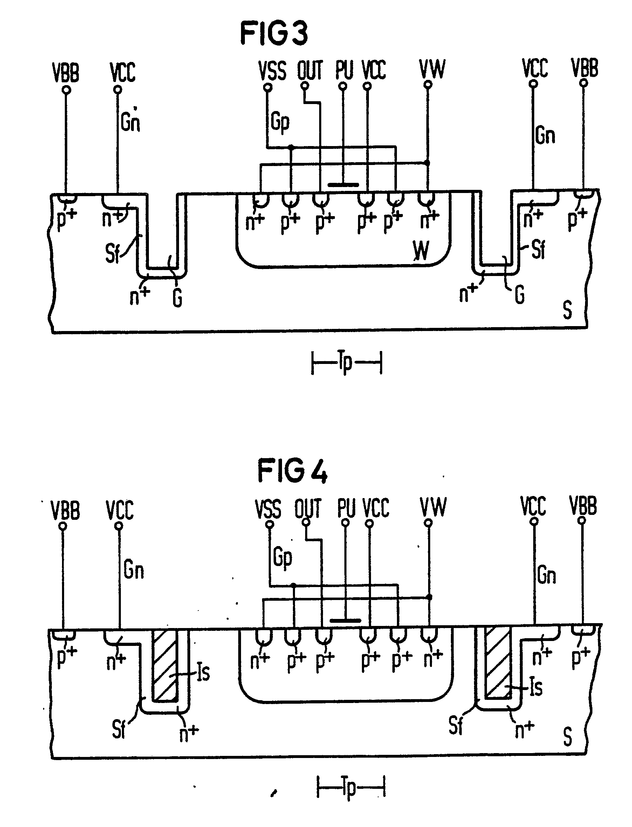

Bei der erfindungsgemäßen Anordnung nach FIG 3 ist das n-dotierte Gebiet n + des Guard Rings Gn des ersten Substratbereiches S erfin-dungsgemäß wenigstens 1μm tief, mindestens jedoch halb so tief in den ersten Substratbereich S hinein ausgeführt wie der zweite Substratbereich W. Dadurch wirkt er, verglichen mit der Anordnung nach FIG 2, noch stärker als Kollektor für die auftretenden Elektronen. Durch diese verstärkte Kollektorwirkung werden die Elektronen, die vom ersten Substratbereich S in den zweiten Substratbereich W diffundieren wollen, effektiv abgefangen, wodurch das Auftreten des Latch-up-Effektes weitestgehend verhindert wird. Der Schutz wird umso stärker, je tiefer (über die beschriebene Mindesttiefe hinaus) der dotierte Bereich n + des Guard Rings Gn in den ersten Substratbereich S reicht.

In der Ausführungsform nach FIG 3 ist der dotierte Bereich n + des Guard Rings Gn als Oberflächenbereich Sf eines im ersten Substratbereich S angeordneten Grabens G ausgeführt. Der Graben G kann, wie in FIG 4 als einer weiteren Ausführungsform gezeigt, mit isolierendem Material (1S) gefüllt sein.

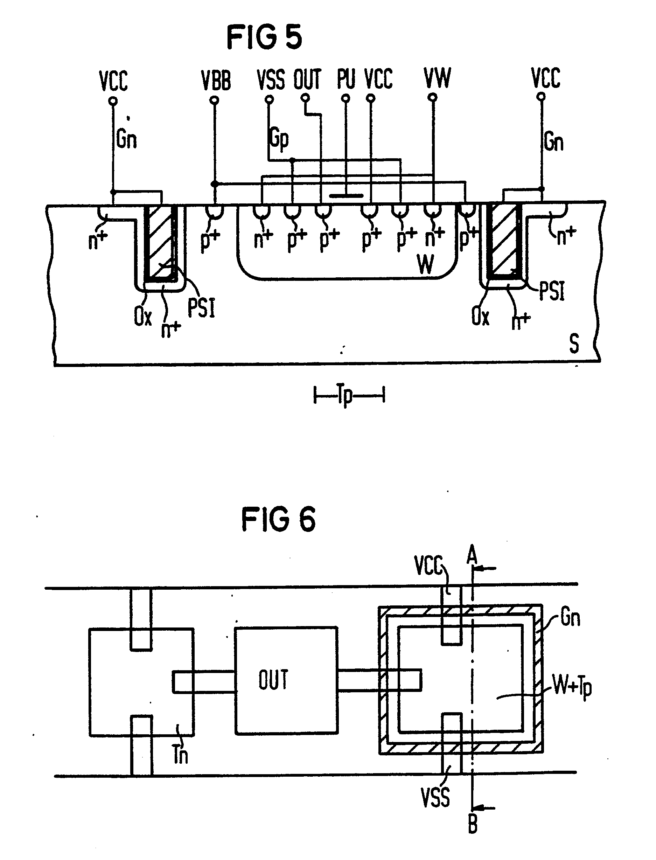

Insbesondere bei der Herstellung von DRAM's mit Trenchzellen als CMOS-Halbleiterschaltung ist es günstig, wenn gemäß der Ausführungsform nach FIG 5 der Graben mit elektrisch leitendem Material PSI, insbesondere mit solchem aus Polysilizium oder einer Silizidverbindung aufgefüllt ist. Dabei kann der dotierte Bereich n + des Guard Rings Gn elektrisch leitend mit dem Material PSI verbunden sein. Ebenso kann zwischen dem Oberflächenbereich Sf und dem elektrisch leitenden Material PSI eine Isolierschicht Ox, insbesondere ein Oxid angeordnet sein (ebenfalls in FIG 5 gezeigt).

Wenigstens in dem Fall, in dem beim Betrieb der erfindungsgemäßen Anordnung am zweiten Substratbereich W ein Wannenpotential VW liegt, das ungleich dem mit dem dotierten Bereich n + verbundenen zweiten Versorgungspotential VCC ist, ist es vorteilhaft, wenn zwischen dem dotierten Bereich n + und dem zweiten Substratbereich W wenigstens ein elektrischer Anschluß p + des ersten Substratbereiches S' vorgesehen ist. Dies ist ebenfalls in FIG 5 gezeigt.

FIG 6 zeigt die vorliegende Erfindung mit den Transistoren Tn und Tp (vgl. auch FIG 1) in Draufsicht, stark schematisiert. Die eingezeichnete Schnittlinie AB entspricht dem Verlauf der Querschnittsdarstellungen nach den FIG 3 bis 5. Der den beiden Transistoren Tn,Tp gemeinsame Ausgang OUT ist der Anschaulichkeit halber als Pad dargestellt.

Die vorstehende Beschreibung betrifft zwar eine Anordnung, bei der der erste Substratbereich S vom p-leitenden Typ ist und bei der der zweite Substratbereich W vom n-leitenden Typ ist (sog. "n-well-Technologie"). Der Fachmann kann diese Erfindung jedoch auch leicht bei der sog. "p-well-Technologie" ausführen unter Vertauschung der genannten Leitungstypen samt zugehörigen Poten-

tialen.

**Ansprüche**

1. Anordnung zur Verminderung von Latch-up-Störanfälligkeit bei CMOS-Halbleiterschaltungen
- mit einem ersten Substratbereich (S) eines ersten Leitfähigkeitstyps (p;n),
- mit einem im ersten Substratbereich (S) angeordneten zweiten Substratbereich (W) eines zum ersten Leitfähigkeitstyp (p;n) entgegengesetzten zweiten Leitfähigkeitstyps (n;p),
- und mit einem dotierten Bereich (n+;p+) vom zweiten Leitfähigkeitstyp (n;p), der entlang einer Hauptfläche des ersten Substratbereiches (5) den zweiten Substratbereich (W) umgibt, **dadurch gekennzeichnet**, daß der dotierte Bereich (n+;p+) wenigstens 1 μm tief ist, mindestens jedoch halb so tief in den ersten Substratbereich (S) hineinreicht wie der zweite Substratbereich (W).

2. Anordnung nach Anspruch 1, **dadurch gekennzeichnet**, daß der dotierte Bereich (n+;p+) als Oberflächenbereich (Sf) eines im ersten Substratbereich (S) angeordneten Grabens (G) ausgeführt ist.

3. Anordnung nach Anspruch 2, **dadurch gekennzeichnet**, daß der Graben (G) mit isolierendem Material (IS) gefüllt ist.

4. Anordnung nach Anspruch 2, **dadurch gekennzeichnet**, daß der Graben (G) mit elektrisch leitendem Material (PSI) gefüllt ist.

5. Anordnung nach Anspruch 4, **dadurch gekennzeichnet**, daß das elektrisch leitende Material elektrisch leitend mit dem dotierten Bereich (n+,p+) verbunden ist.

6. Anordnung nach einem der Ansprüche 3 bis 5, **dadurch gekennzeichnet**, daß zwischen dem Oberflächenbereich (Sf) und dem Material (IS;PSI) der Grabenfüllung eine Isolier schicht (Ox), insbesondere ein Oxid angeordnet ist.

7. Anordnung nach einem der vorhergehenden Ansprüche, **dadurch gekennzeichnet**, daß wenigstens in dem Fall, in dem beim Betrieb der Anordnung am zweiten Substratbereich (W) ein Wannenpotential (VW) liegt, das ungleich einem am dotierten Bereich (n+;p+) liegenden Potential (VCC) ist, zwischen dem dotierten Bereich (n+;p+) vom zweiten Leitfähigkeitstyp (n;p) und dem zweiten Substratbereich (W) wenigstens ein elektrischer Anschluß (p+;n+) des ersten Substratbereiches (S) vorgesehen ist.

FIG 1

FIG 2

## FIG 3

VBB   VCC          VSS  OUT  PU  VCC        VW          VCC   VBB

Gn                 Gp                                    Gn

p+   n+            n+  p+  p+  p+  p+  n+              n+   p+

Sf                                          W        Sf

n+   G                                  n+   G        S

|—Tp—|

## FIG 4

VBB   VCC          VSS  OUT  PU  VCC        VW          VCC   VBB

Gn                 Gp                                    Gn

p+   n+            n+  p+  p+  p+  p+  n+              n+   p+

Is                                                    Is

Sf   n+                                      Sf   n+   S

|—Tp—|

# FIG 5

# FIG 6

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 283 046 (NEC) <br> * Spalte 4, Zeilen 37-43; Figur 3 * <br> --- | 1 | H 01 L 27/092 |
| X | PATENT ABSTRACTS OF JAPAN, Band 11, Nr. 31 (E-475)[2478], 29. Januar 1987; & JP-A-61 199 654 (NEC CORP.) 04-09-1986 <br> * Figur 2 * <br> --- | 1-3 | |
| Y | Idem <br> --- | 4,6 | |
| X | WO-A-8 401 241 (SEMI PROCESSES INC.) <br> * Figur 1; Seite 5, Zeilen 22-30 * <br> --- | 1,7 | |
| Y | EP-A-0 138 517 (AMERICAN TELEPHONE AND TELEGRAPH CO.) <br> * Figur 2; Seite 4, Zeilen 29-37 * <br> ----- | 4,6 | |

**RECHERCHIERTE SACHGEBIETE (Int. Cl.5)**

H 01 L 27/00

Der vorliegende Recherchenbericht wurde für alle Patentansprüche erstellt

| Recherchenort | Abschlußdatum der Recherche | Prüfer |
|---|---|---|
| DEN HAAG | 12-09-1989 | ZEISLER P.W. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)